Europäisches Patentamt

(19) European Patent Office

Office européen des brevets

(11) **EP 1 324 496 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(51) Int Cl.7: **H03M 1/14**, H02P 7/00, H02H 3/00, H03M 1/50, G08C 19/22, H02P 6/00

(21) Anmeldenummer: **02024092.5**

(22) Anmeldetag: **29.10.2002**

(54) **Verfahren und Anordnung zur Digitalisierung einer Spannung**

Method and arrangement for digitising a voltage

Procédé et montage pour la numérisation d'une tension

(84) Benannte Vertragsstaaten:
**AT BE BG CH CY CZ DE DK EE ES FI FR GB GR IE IT LI LU MC NL PT SE SK TR**

(30) Priorität: **22.12.2001 DE 10163374**

(43) Veröffentlichungstag der Anmeldung:
**02.07.2003 Patentblatt 2003/27**

(73) Patentinhaber: **ebm-papst St. Georgen GmbH & Co. KG**
**78112 St. Georgen (DE)**

(72) Erfinder:
• **Berroth, Hansjörg**
**78052 Villingen-Schwenningen (DE)**

• **Kuner, Arnold**
**78112 St. Georgen (DE)**
• **Schondelmaier, Hans-Dieter**
**78112 St. Georgen (DE)**

(74) Vertreter: **Raible, Hans, Dipl.-Ing.**
**Schoderstrasse 10**
**70192 Stuttgart (DE)**

(56) Entgegenhaltungen:
**EP-A- 0 525 372**      **DE-A- 19 836 882**
**US-A- 5 831 568**

• **PATENT ABSTRACTS OF JAPAN vol. 013, no. 301 (E-785), 11. Juli 1989 (1989-07-11) & JP 01 078030 A (SANYO ELECTRIC CO LTD), 23. März 1989 (1989-03-23)**

**Beschreibung**

Die Erfindung betrifft ein Verfahren zur Digitalisierung der Spannung an einem Kondensator, und eine Anordnung zur Durchführung eines solchen Verfahrens.

Zur Digitalisierung einer analogen Spannung sind manche Mikrocontroller (µC) mit einem A/D-Wandler ausgestattet, der eine relativ grobe Digitalisierung ermöglicht, z.B. mit einer Genauigkeit von 4 Bit. Gewöhnlich benötigt man aber für z. B. digitale Regler eine höhere Genauigkeit, z.B. von 8 Bit, und benötigt folglich eine höhere Auflösung bei der A/D-Wandlung, als sie mit der Hardware eines solchen µC möglich ist.

Aus der DE 198 36 882 A1 kennt man eine Anordnung für einen Elektromotor, dessen Drehzahl temperaturabhängig gesteuert werden soll. Für diese Temperatur liegt ein analoger Wert vor in Gestalt eines ersten Potentials an eine Spannungsteiler. Dieses Potential wird dem einen Eingang eines Komparators zugeordnet. Ferner hat diese Anordnung einen Kondensator, und die Spannung an diesem Kondensator wird dem anderen Eingang des Komparators zugeführt.

Ausgehend von der Spannung 0 wird dieser Kondensator über ein Konstantstromglied aufgeladen, und dabei wird die Zeit der Aufladung als analoger Wert erfasst, nämlich in Form eines Impulses mit temperaturabhängiger Länge.

Die Dauer des hierbei entstandenen Pulses wird dann mittels eines digitalen Zählers digitalisiert, und der hierbei erfasste digitale Wert dient zur Regelung der Drehzahl des Motors.

Aus der US 58 31 568 ist es bekannt, zur Digitalisierung eines elektrischen Potentials Zeitmessungen zu verwenden. Eine erste Zeitmessung bei der Ladungsänderung eines Kondensators bekannter Größe dient dazu, den elektrischen Wert einer Schaltschwelle zu "lernen", wozu eine erste Zeit gemessen und in einem Speicher hinterlegt wird.

Anschließend erfolgt, ausgehend von dem zu messenden Potential, eine Ladungsänderung dieses Kondensators, und eine zweite Zeit, die dem Beginn der Ladung bis zum Erreichen der Schaltschwelle benötigt wird, wird gemessen.

Aus den Werten für die erste und die zweite Zeit, sowie der Größe dieses Kondensators und eines Widerstands mit ebenfalls bekannter Größte wird dann nach einer bestimmten Formel ein digitaler Wert errechnet, der das zu messende Potential charakterisiert.

Es ist eine Aufgabe der Erfindung, ein neues Verfahren zur Digitalisierung einer Spannung, sowie eine Anordnung zur Durchführung eines solchen Verfahrens, bereit zu stellen.

Nach der Erfindung wird diese Aufgabe gelöst durch das Verfahren gemäß Patentanspruch 1.

Die Ermittlung von erster und zweiter Grenze kann mit der Hardware erfolgen, die in manchen Mikrocontrollern vorhanden ist, und sie ergibt eine grobe Digitalisierung, also eine Grobinformation. Die anschließende aktive Änderung der Spannung am Kondensator ermöglicht eine genauere Digitalisierung, bei der die Größe dieses Kondensators nur dafür eine Rolle spielt, wie lange die Messung dauert, nicht aber für ihre Genauigkeit. Da diese aktive Änderung nur in einem kleinen Spannungsbereich erfolgt, ergeben sich keine wesentlichen Probleme durch Nicht-Linearitäten. Auf diese Weise kann man die Genauigkeit einer A/D-Wandlung mit einfachsten Mitteln und ohne wesentliche Mehrkosten erhöhen, weil man nun zusätzlich zur Grobinformation (durch den ermittelten Spannungsbereich) eine Feininformation darüber erhält, auf welchem Niveau zwischen erster und zweiter Grenze dieses Spannungsbereichs der Spannungswert am Kondensator liegt. Eine erfindungsgemäße Anordnung ist Gegenstand des Patentanspruchs 7. Eine solche Anordnung hat einen einfachen Aufbau bei hoher Messgenauigkeit.

Eine bevorzugte Verwendung ist Gegenstand der Ansprüche 14 bis 18.

Weitere Einzelheiten und vorteilhafte Weiterbildungen der Erfindung ergeben sich aus dem im folgenden beschriebenen und in der Zeichnung dargestellten, in keiner Weise als Einschränkung der Erfindung zu verstehenden Ausführungsbeispiel, sowie aus den Unteransprüchen. Es zeigt:

Fig. 1    eine Anordnung zur Digitalisierung einer analogen Spannung,

Fig. 2    eine schematische Darstellung zur Erläuterung des Verfahrensablaufs,

Fig. 3    ein Flussdiagramm zur Erläuterung des Verfahrensablaufs,

Fig. 4    ein Schaubild, welches die Verwendung der Erfindung bei einem elektronisch kommutierten Motor 156 beispielhaft zeigt,

Fig. 5    ein Übersichtsbild der Programmstruktur,

Fig. 6    die Grundstruktur eines Programms zur Steuerung eines Motors und im wesentlichen gleichzeitigen Erfassung eines Sollwerts,

Fig. 7 eine Tabelle zur Erläuterung von Fig. 6, und

Fig. 8 das Flussdiagramm einer Interrupt-Service-Routine.

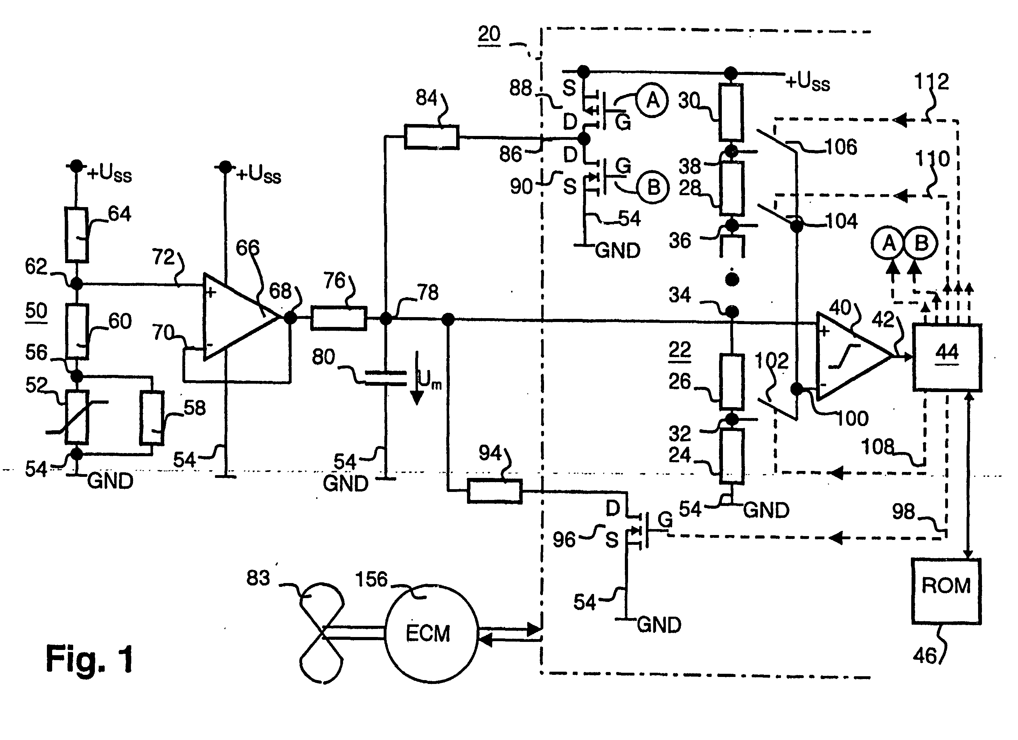

**Fig. 1** zeigt rechts einen Rechner 20, z.B. einen μC vom Typ Microchip 16C621A. Dieser enthält eine Widerstandskette 22, die an einer konstanten Spannung Uss von z.B. +3,0 V liegt und fünfzehn Widerstände enthält, die bei 24, 26, 28, 30 teilweise angedeutet sind. Einige der Knotenpunkte zwischen diesen Widerständen sind bei 32, 34, 36, 38 angedeutet. Fig. 1 zeigt nur einen kleinen Teil dieser Widerstandskette 22.

Ferner enthält der μC 20 einen Komparator 40, dessen Ausgang 42 mit der Schaltlogik (ALU) 44 des μC 20 verbunden ist, dem ein Programm in einem ROM 46 zugeordnet ist, welches hier bevorzugt Bestandteil des C 20 ist und gewöhnlich bei dessen Herstellung programmiert wird.

Die Anordnung bei dem Beispiel nach Fig. 1 dient dazu, ein Potenzial an einem Knotenpunkt 62 eines Spannungsteilers 50 zu digitalisieren. Letzterer enthält einen NTC-Widerstand 52, der zwischen Masse 54 und einem Knotenpunkt 56 angeordnet ist und zu dem ein Widerstand 58 parallelgeschaltet ist, dessen Funktion es ist, den Bereich der Ausgangssignale des Spannungsteilers 50 für die nachfolgende Digitalisierung zu optimieren.

Der Knotenpunkt 56 ist über einen Widerstand 60 mit dem Knotenpunkt 62 verbunden, und dieser ist über einen Widerstand 64 mit der geregelten Spannung Uss verbunden.

Ein Komparator 66 ist dadurch als Impedanzwandler geschaltet, dass sein Ausgang 68 mit dem negativen Eingang 70 verbunden ist. Der positive Eingang 72 ist mit dem Knotenpunkt 62 verbunden. Man erkennt hier die Funktion des Widerstands 60: Wenn der NTC-Widerstand 52 durch einen Fehler kurzgeschlossen wird, erhält man wegen des Widerstands 60 am Knotenpunkt 62 ein von Masse verschiedenes Potenzial und vermeidet so, dass bei der Digitalisierung ein Fehlerzustand gemeldet wird.

Der Impedanzwandler 66 wird also durch das Potenzial am Knotenpunkt 62 gesteuert, verhindert aber, dass von seinem Ausgang eine Rückwirkung auf den NTC-Widerstand 52 stattfindet.

Der Ausgang 68 des Impedanzwandlers 66 ist über einen Widerstand 76 mit einem Knotenpunkt 78 verbunden, der über einen Kondensator 80 mit Masse 54 verbunden ist.

Im Betrieb lädt sich der Kondensator 80 über den Impedanzwandler 66 und den Widerstand 76 auf einen Spannungswert Um auf, der eine Funktion des Potenzials am Knotenpunkt 62 ist, also eine Funktion der Temperatur am NTC-Widerstand 52. Dieser Spannungswert Um am Kondensator 80 wird durch die Anordnung gemäß Fig. 1 digitalisiert, also in einen Zahlenwert umgewandelt, welcher dann z.B. als Basis für die Generierung eines Sollwerts für die Drehzahl eines elektronisch kommutierten Motors (ECM) 156 dient. Dieser kann z.B. zum Antrieb eines Lüfters 83 dienen, der, ebenso wie der Motor 156, nur symbolisch angedeutet ist. Wenn die Temperatur am NTC-Widerstand 52 niedrig ist, erhält der Lüfter 83 z.B. eine niedrige Drehzahl, und wenn diese Temperatur hoch ist, eine hohe Drehzahl.

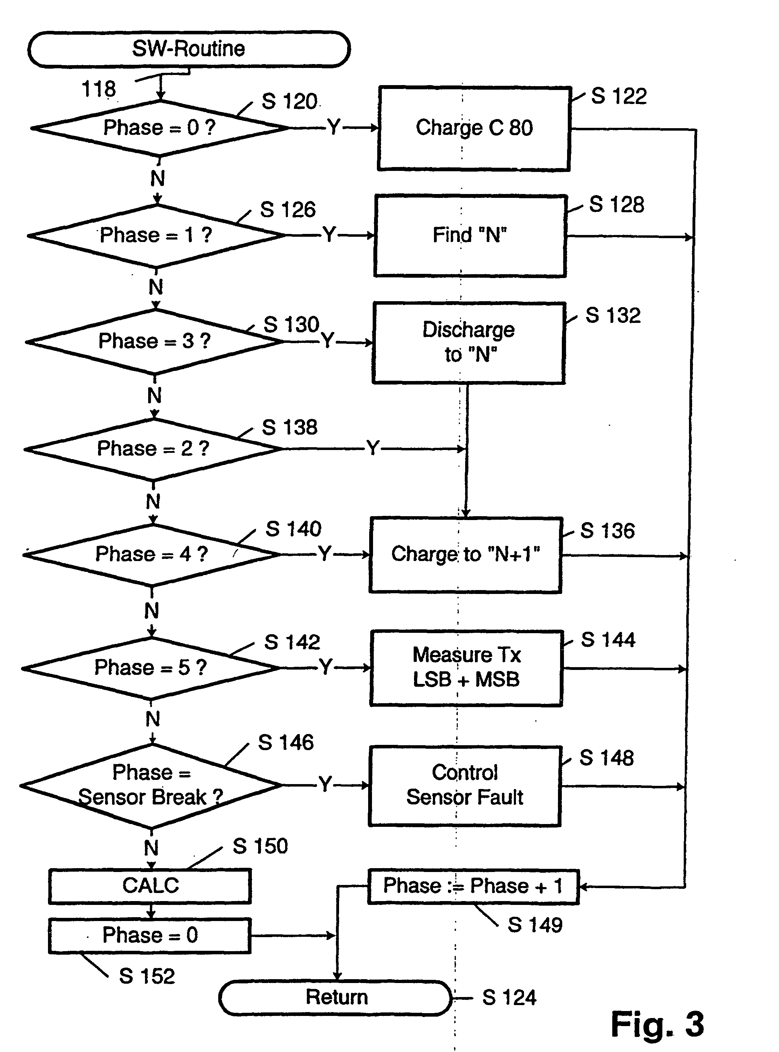

Der Knotenpunkt 78 ist mit dem Pluseingang des Komparators 40 verbunden, und er ist über einen im Vergleich zum Widerstand 76 niederohmigen Widerstand 84 mit einem Knotenpunkt 86 verbunden, an den der Drain-Anschluss D eines P-Kanal-MOSFETs 88 angeschlossen ist, dessen Source S an + Uss liegt, und an den der Drain-Anschluss D eines N-Kanal-MOSFETs 90 angeschlossen ist, dessen Source S mit Masse 54 verbunden ist. Die MOSFETs 88, 90 sind Bestandteile des μC 20, und ihre Gates G werden über Wirkverbindungen A, B von dessen Logikeinheit 44 entsprechend dem Programm (Fig. 3) im ROM 46 gesteuert.

Ferner ist der Knotenpunkt 78 über einen Widerstand 94 mit dem Drain-Anschluss eines N-Kanal-MOSFETs 96 (im μC 20) verbunden, dessen Source S mit Masse 54 verbunden ist. Das Gate G des Transistors 96 wird über eine Verbindung 98 von der Logikeinheit 44 gesteuert.

Der Minuseingang 100 des Komparators 40 kann über einen elektronischen Schalter 102 mit dem Knotenpunkt 32 verbunden werden, ebenso über einen elektronischen Schalter 104 mit dem Knotenpunkt 36, ebenso über einen elektronischen Schalter 106 mit dem Knotenpunkt 38 (und analog über zusätzliche, nicht dargestellte elektronische Schalter mit den übrigen Knotenpunkten der Widerstandskette 22).

Der elektronische Schalter 102 wird über eine Wirkverbindung 108 von der Logikeinheit 44 gesteuert. Ebenso wird der elektronische Schalter 104 über eine Wirkverbindung 110, und der elektronische Schalter 106 über eine Wirkverbindung 112, von der Logikeinheit 44 gesteuert, ebenso alle übrigen elektronischen Schalter.

**Arbeitsweise**

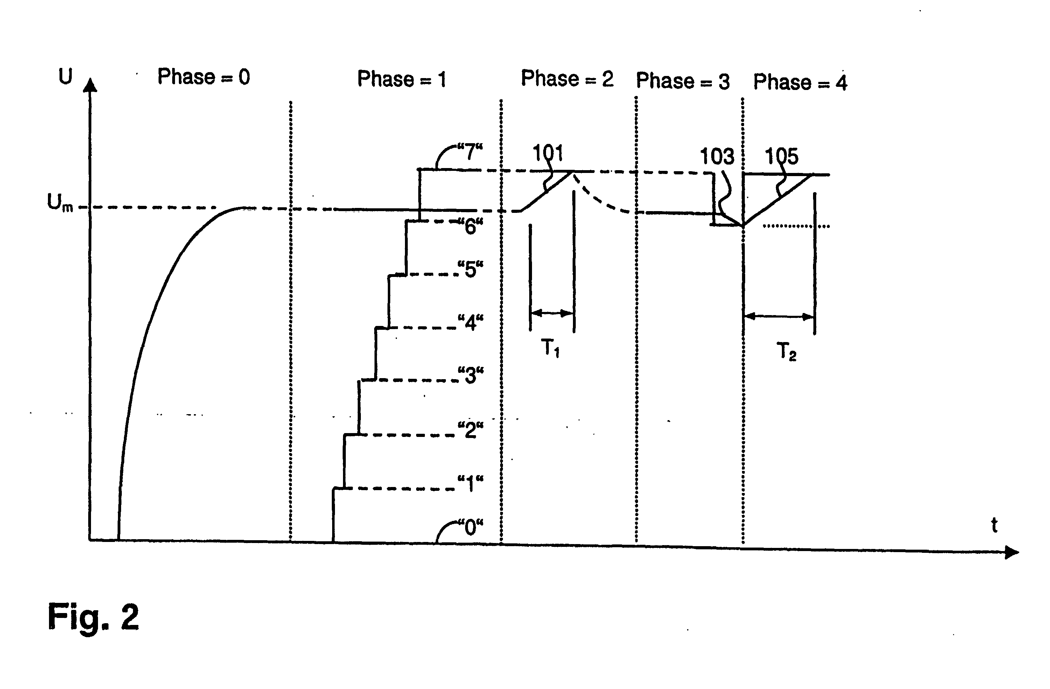

Gemäß **Fig. 2** wird der Kondensator 80 zunächst in einer Phase = 0 über den Impedanzwandler 66 und die Impedanz 76 auf einen Spannungswert Um aufgeladen, der beim Ausführungsbeispiel eine Funktion der Temperatur am NTC-Widerstand 52 ist.

Anschließend wird in einer Phase = 1 mit Hilfe der Widerstandskette 24, 26, ... 28, 30 festgestellt, in welchem von mehreren Spannungsbereichen dieser Spannungswert Um liegt.

Das Potenzial an Masse 54 beträgt 0 V, das am Knotenpunkt 32 0,2 V, das am Knotenpunkt 34 0,4 V, und so herauf bis zum Knotenpunkt 36 mit 2,6 V und dem Knotenpunkt 38 mit 2,8 V.

Wird der Schalter 102 geschlossen, so erhält der Minuseingang des Komparators 40 ein Potenzial von +0,2 V, und wenn das Potenzial am Knotenpunkt 78 größer ist als 0,2 V, so ändert sich am Ausgang 42 des Komparators 40 nichts.

Bei der Grobmessung werden nacheinander die verschiedenen elektronischen Schalter 102, 104, 106 etc. einzeln geschlossen. Wenn das Potenzial am Knotenpunkt 36 (2,6 V) noch niedriger ist als der Spannungswert Um am Kondensator 80, das Potenzial am Knotenpunkt 38 (2,8 V) aber höher, so weiß man, dass dieser Spannungswert Um zwischen 2,6 und 2,8 V liegen muss, d.h. die untere Grenze des ermittelten Spannungsbereichs ist 2,6 V, und die obere Grenze ist 2,8 V. Daraus ergibt sich eine grobe Digitalisierung des Spannungswertes Um, oder anders gesagt, man erhält so die höherwertigen Bits MSB bei der Digitalisierung.

Anschließend wird in einer Phase = 2 (Fig. 2) der Transistor 88 eingeschaltet, während der Transistor 90 gesperrt bleibt. Dadurch wird über den Transistor 88 und den Widerstand 84 der Kondensator 80 geladen, wie in Fig. 2 bei 101 dargestellt. Hierbei bleibt der elektronische Schalter 106 geschlossen, und wenn das Potenzial am Pluseingang des Komparators 40 den Wert 2,8 V erreicht, schaltet der Komparator 40 um, und über die Logikeinheit 44 und deren Wirkverbindung A wird der Transistor 88 wieder nichtleitend gemacht. Die Zeit $T_1$, während deren der Transistor 88 geschlossen ist, wird hierbei gemessen und gespeichert.

Anschließend wird der Kondensator 80 über den Widerstand 84 und den Transistor 90 bis zur unteren Grenze des Spannungsbereichs, beim Beispiel also bis +2,6 V, entladen, wie in Fig. 2 bei 103 dargestellt. Die Spannung am Kondensator 80 beträgt dann 2,6 V. Während dieses Vorgangs wird der Schalter 106 geöffnet, und der Schalter 104 wird geschlossen.

Dann wird der Transistor 90 gesperrt, der Transistor 88 wird eingeschaltet, der Schalter 104 wird geöffnet, und der Schalter 106 wird eingeschaltet. Dies geschieht durch die Logikeinheit 44, gesteuert vom Programm im ROM 46.

Dadurch wird der Kondensator 80 über den Transistor 88 und den Widerstand 84 von +2,6 V auf +2,8 V aufgeladen, wie in Fig. 2 bei 105 dargestellt. Hierbei wird eine Zeit $T_2$ gemessen, während deren der Transistor 88 leitend ist. Dies geschieht in Phase = 4 (Fig. 2).

Die verschiedenen Phasen in Fig. 2 haben folgenden Grund: Wenn die Erfindung bei einem elektronisch kommutierten Motor 156 verwendet wird, was eine bevorzugte Anwendung ist, muss der µC 20 auch viele andere Aufgaben durchführen, z.B. die Kommutierung des Motors 156, dessen Drehzahlregelung, dessen Strombegrenzung, etc., weshalb es günstig ist, die beschriebene Messung in verschiedene kurze Module aufzuteilen, die nicht direkt nacheinander, sondern mit kleinen zeitlichen Abständen, ausgeführt werden können. Der µC 20 hat dann immer wieder Zeit, um andere, zeitkritische Funktionen zwischendurch auszuführen. Deshalb stellt es einen großen Vorteil des erfindungsgemäßen Verfahrens und der erfindungsgemäßen Anordnung dar, dass die Messung in verschiedene kurze Module aufgeteilt werden kann.

Wenn die Zeiten $T_1$ und $T_2$ gemessen sind, wird aus ihnen nach der Formel

$$\text{LSBs} = (T_2 - T_1)/T_2 * 16 \tag{1}$$

der Wert für die niederwertigen Bits (LSBs) berechnet.

Wenn z.B. $T_1 = T_2$ ist, ergibt sich aus der Gleichung (1) der binäre Wert 0000b.

Da man die Ladung über den Widerstand 84 und den Transistor 88 als nahezu linear ansehen kann, spielt hierbei die Größe des Kondensators 80 nur insofern eine Rolle, als ein größerer Kondensator eine längere Ladezeit, also eine längere Messzeit bedeutet. Deshalb spielen bei dieser Art von Messung die Toleranzen des Kondensators 80 keine Rolle, und man erhält ein sehr genaues Ergebnis der Fein-Digitalisierung.

Wird bei der Messung in Phase = 1 festgestellt, dass der Spannungswert Um am Kondensator 80 größer als 2,8 V ist, so wird durch die Logikeinheit 44 der Transistor 96 eingeschaltet, der den Knotenpunkt 78 über den Widerstand 94 mit Masse 54 verbindet. Die Widerstände 76 und 94 bilden dann einen Spannungsteiler, und der zu messende Spannungswert am Kondensator 80 wird entsprechend reduziert. Dadurch kann man die Spannung am Kondensator 80 in einen Bereich unterhalb 2,8 V absenken, so dass eine Messung möglich wird. Das Ergebnis muss dann mit einem Faktor multipliziert werden, der sich aus dem Verhältnis der Widerstände 76 und 94 ergibt.

**Bevorzugte Werte der Bauelemente**

| k = kOhm; Spannung Uss = 3,1 V |
| --- |

(fortgesetzt)

| µC 20 | Microchip 16C621 A |
|---|---|
| Komparator 66 | Bestandteil des Microchip 16C621A |
| Widerstand 52 | NTC, 100 k bei 25° C |
| Widerstand 58 | 510 k |
| Widerstand 60 | 1 k |
| Widerstand 64 | 110 k |
| Widerstand 76 | 10 k |
| Widerstand 84 | 1 k |
| Widerstand 94 | 27 k |
| Kondensator 80 | 1 µF |

**Fig. 3** zeigt eine bevorzugte Programmroutine für die Messung. Dieser ist bevorzugt Bestandteil eines größeren Programms, z.B. für die Steuerung eines elektronisch kommutierten Motors. Der Aufbau dieser Routine "SW Routine" beruht auf der Überlegung, dass bei jedem Durchlauf nur kurze Programmteile (Module) ausgeführt werden, deren Dauer z.B. kleiner als 200 µs ist.

Als erstes wird nach dem Beginn 118 dieser Routine bei S120 abgefragt, ob sich das Programm in Phase = 0 befindet. Das ergibt sich aus dem Zustand eines übergeordneten Phasenzählers oder Pointers, der fortlaufend folgende Zustände durchläuft:

Phase = 0
Phase = 1
Phase = 2
Phase = 3
Phase = 4
Phase = 5
Phase = Sensor Break
Phase = 0
Phase = 1
etc.

Man kann das auch als eine State Machine bezeichnen, d.h. es handelt sich in der Praxis um eine Variable im RAM des Prozessors, die ständig auf den laufenden Stand gebracht wird und anzeigt, in welchem Stadium sich die Sollwerterfassung gerade befindet.

Ist in S120 die Antwort Ja, so geht das Programm zu S122 "Charge C", d.h. die Transistoren 88, 90 und 96 werden gesperrt, damit sich der Kondensator 80 auf den zu messenden Spannungswert Um aufladen kann, und das Programm wartet eine entsprechende Zeit. Anschließend geht es über S149 zum Ende S124 dieser Routine, wobei der Phasenzähler in S149 von Phase = 0 auf Phase = 1 weitergezählt wird.

Lautet in S120 die Antwort Nein, so geht das Programm zu S126, wo geprüft wird, ob sich der Pointer bei Phase = 1 befindet. Falls Ja, wird in S128 "Find "N""durch Ein- und Ausschalten der elektronischen Schalter 102, 104, 106 etc. der Spannungsbereich N ermittelt, in dem sich die zu messende Spannung am Kondensator 80 befindet. Wenn z.B. die Spannung am Kondensator 80 2,7 V beträgt, liegt der Spannungsbereich N zwischen 2,6 und 2,8 V. Durch diese Einordnung in einen von mehreren Spannungsbereichen erfolgt eine grobe Digitalisierung, und man erhält die höherwertigen Bits MSB für die Digitalisierung.

Nach der Ermittlung dieses Spannungsbereichs geht das Programm über S149 zum Ende S124 der Routine, und der Phasenzähler wird in S149 auf Phase = 2 weitergezählt.

Lautet in S126 die Antwort Nein, so geht das Programm zu S130. Dort wird geprüft, ob sich der Pointer bereits in Phase = 3 befindet. Falls Ja, wird in S132 "Discharge to "N"" der Kondensator 80 auf die untere Grenze des Spannungsbereichs N entladen, beim beschriebenen Beispiel also auf 2,6 V. Anschließend geht das Programm direkt zu S136 "Charge to N+1", wo der Kondensator 80 - beim Beispiel - ausgehend von 2,6 V auf die Obergrenze des Spannungsbereichs N geladen wird, also auf 2,8 V. Hierbei wird die Zeit $T_2$ gemessen. Anschließend geht das Programm zum Ende S124 der Routine, und der Phasenzähler wird bei S149 auf Phase = 4 weitergezählt.

Lautet die Antwort in S130 Nein, so geht das Programm zu S138. Dort wird geprüft, ob der Pointer auf Phase = 2 zeigt. Falls Ja, geht das Programm zu S136, und dort wird der Kondensator 80 von seiner zu messenden augenblicklichen Spannung Um auf die obere Spannungsgrenze N+1 des Spannungsbereichs N aufgeladen, beim beschriebenen Beispiel also auf +2,8 V. Dabei wird die Zeit $T_1$ gemessen, vgl. Fig. 2. Anschließend geht das Programm zum Ende S124 der Routine, und der Phasenzähler wird bei S149 auf Phase = 3 weitergezählt.

Ist die Antwort in S138 Nein, so geht das Programm zu S140, und dort wird geprüft, ob der Pointer auf Phase = 4 zeigt. Falls Ja, wird in S136 der Kondensator 80, ausgehend von der unteren Grenze des Spannungsbereichs N (beim Beispiel also von 2,6 V) bis zur oberen Grenze N+1 (beim Beispiel also bis 2,8 V) aufgeladen, und gleichzeitig wird die Zeit $T_2$ gemessen, wie in Fig. 2 dargestellt und dort bereits ausführlich beschrieben. Anschließend wird der Phasenzähler in S149 auf Phase = 5 weitergezählt.

Lautet die Antwort bei S140 Nein, so geht das Programm zu S142, und dort wird geprüft, ob der Pointer auf Phase = 5 zeigt. Falls Ja, geht das Programm zu S144. Dort werden nach Gleichung (1) die niederwertigen Bits LSB ausgerechnet und zu den höherwertigen Bits MSB addiert, die zuvor in S128 ermittelt wurden. Man hat dann die Spannung Um am Kondensator 80 digitalisiert. Anschließend wird der Phasenzähler in S149 auf "Phase = Sensor Break" weitergezählt.

Lautet in S142 die Antwort Nein, so geht das Programm zu S146. Dort wird geprüft, ob der Phasenzähler auf "Phase = Sensor Break" zeigt. Falls Ja, geht das Programm zu S148 "CTRL Sensor Fault". Dort wird geprüft, ob die Spannung am Kondensator 80 etwa den Wert Uss erreicht hat, was einer Unterbrechung der Verbindung zum Widerstand 52 entspricht. In diesem Fall wird eine entsprechende Maßnahme eingeleitet, z.B. die Ausgabe eines Fehler- oder Alarmsignals, und bei einem Motor 156 für einen Lüfter 83 wird die Drehzahl auf einen solchen Wert erhöht, dass die Kühlung auf jeden Fall sichergestellt ist. Anschließend geht das Programm über S149 zum Ende S124 der Routine.

Falls in S146 die Antwort Nein lautet, geht das Programm zu S150, wo beliebige Programmschritte "CALC" ausgeführt werden. Z.B. kann der in S144 berechnete digitale Wert über eine Tabelle in einen anderen Wert umgesetzt werden, welcher einer gewünschten Motordrehzahl entspricht, und es kann ein gleitender Mittelwert (moving average; sliding average) aus mehreren Messungen gebildet werden.

Anschließend wird in S152 der Pointer wieder auf Phase = 0 zurückgesetzt, damit beim nächsten Durchlauf durch die Routine der Fig. 3 die Messung wieder bei S120 beginnt.

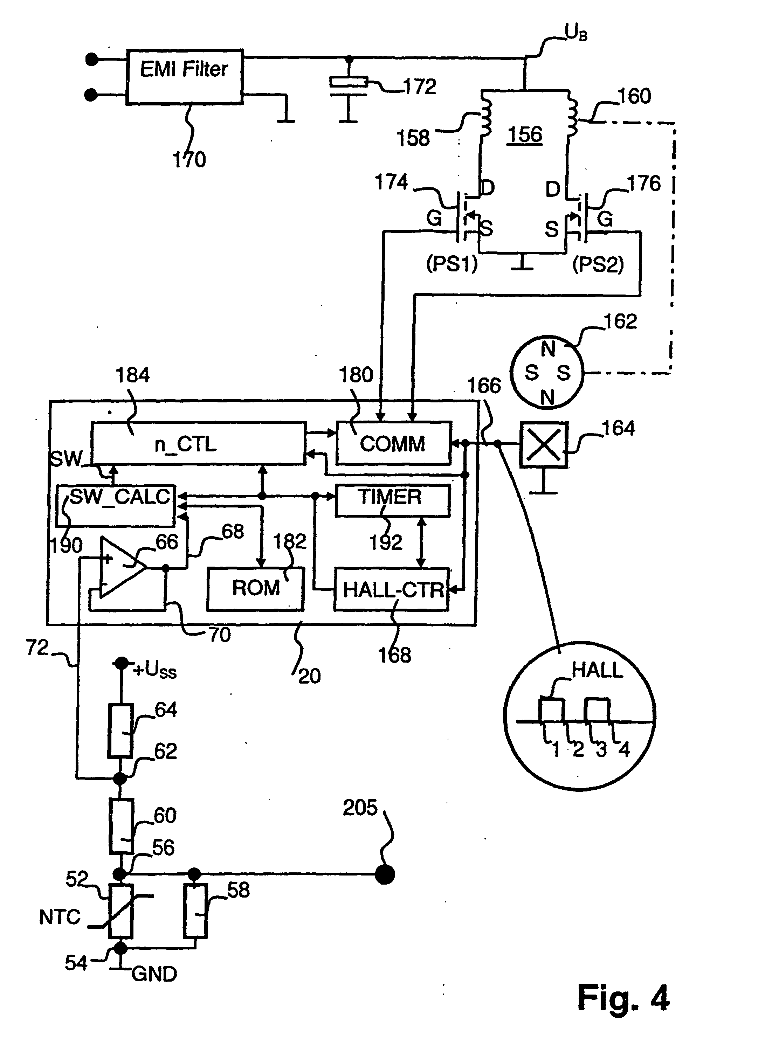

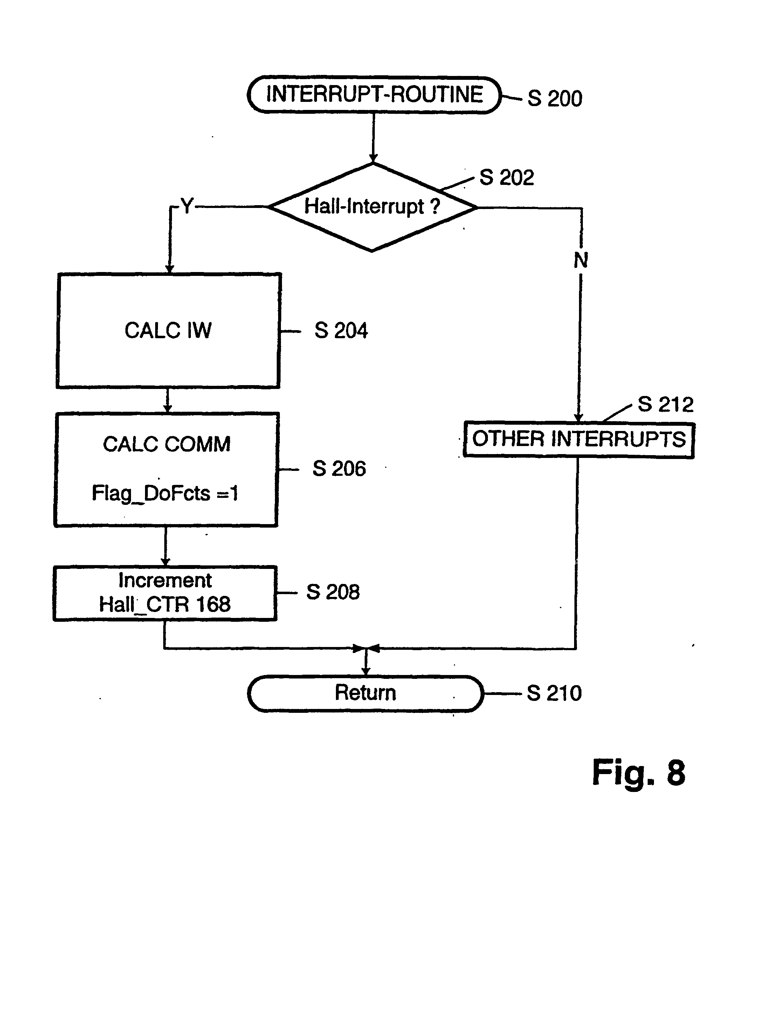

Fig. 4 erläutert eine bevorzugte Anwendung der Erfindung bei einem elektronisch kommutierten Motor (ECM) 156 mit zwei Statorwicklungsphasen 158, 160 und einem permanentmagnetischen Rotor 162, der hier vierpolig dargestellt ist und in dessen Nähe ein Hallgenerator 164 angeordnet ist, der im Betrieb an seinem Ausgang 166 ein rechteckförmiges Signal HALL erzeugt, dessen Flanken beispielhaft mit 1, 2, 3, 4 bezeichnet sind. Bei jeder dieser Flanken wird ein Hallinterrupt (Fig. 8) erzeugt, und dabei werden diese Flanken fortlaufend in einem Ringzähler HALL_CTR 168 gezählt.

Zur Versorgung mit einer Gleichspannung $U_B$ hat der Motor 156 ein EMI-Filter 170 und einen Siebkondensator 172. In Reihe mit dem Strang 158 liegt ein Transistor 174, der als erste Endstufe (PS1) dient, und in Reihe mit dem Strang 160 liegt ein Transistor 176, der als zweite Endstufe (PS2) dient. Ist der Transistor 174 eingeschaltet, erhält der Strang 158 Strom. Ist der Transistor 176 eingeschaltet, so erhält der Strang 160 Strom.

Zur Steuerung der Transistoren 174, 176 dient der Microcontroller (µC) 20. In ihm sind symbolisch verschiedene Module dargestellt, u. a. ein Modul COMM 180 für die Kommutierung des Motors 156, ein ROM 182 (innerhalb oder außerhalb des µC 20) zur Speicherung des Programmes für den Motor 156, ein Modul n _CTL 184 für die Drehzahlregelung, das über das Modul 180 die Drehzahl des Motors 156 regelt, ferner ein Modul SW_CALC 190 für die Berechnung des Sollwertes SW, der dem Drehzahlregler 184 zugeführt wird. Der aktuelle Wert der Drehzahl, also der Istwert IW, wird dem Regler 184 in Gestalt des Signals HALL zugeführt, ebenso den Modulen 180 und 168. Ferner enthält der µC 20 einen Timer 192, den man sich als eine Uhr vorstellen kann, welche zu jedem gewünschten Zeitpunkt eine sogenannte Basiszeit liefert. Der Timer 192 arbeitet mit den Modulen 168, 184 und 190 zusammen.

Eine Spannung zur Berechnung des Sollwerts SW wird dem Modul 190 über den Impedanzwandler 66 zugeführt. Seinem positiven Eingang 72 wird das Signal vom Knotenpunkt 62 eines Spannungsteilers 52, 58, 60, 64 zugeführt, der bei Fig. 1 ausführlich beschrieben wurde, vgl. die dortige Beschreibung.

Das Signal am Ausgang 68 des Impedanzwandlers 66 wird im Modul 190 gemäß Fig. 1 bis 3 in einen Sollwert umgesetzt, also in eine gewünschte Drehzahl. Z. B. kann der Motor 156 mit 1 500 U/min laufen, wenn die Temperatur am Widerstand 52 20° C beträgt und mit 3 500 U/min, wenn diese Temperatur 60° C beträgt. Über einen Eingang 205 kann auch von außen ein Sollwert in Form einer Spannung dem Knotenpunkt 56 zugeführt werden.

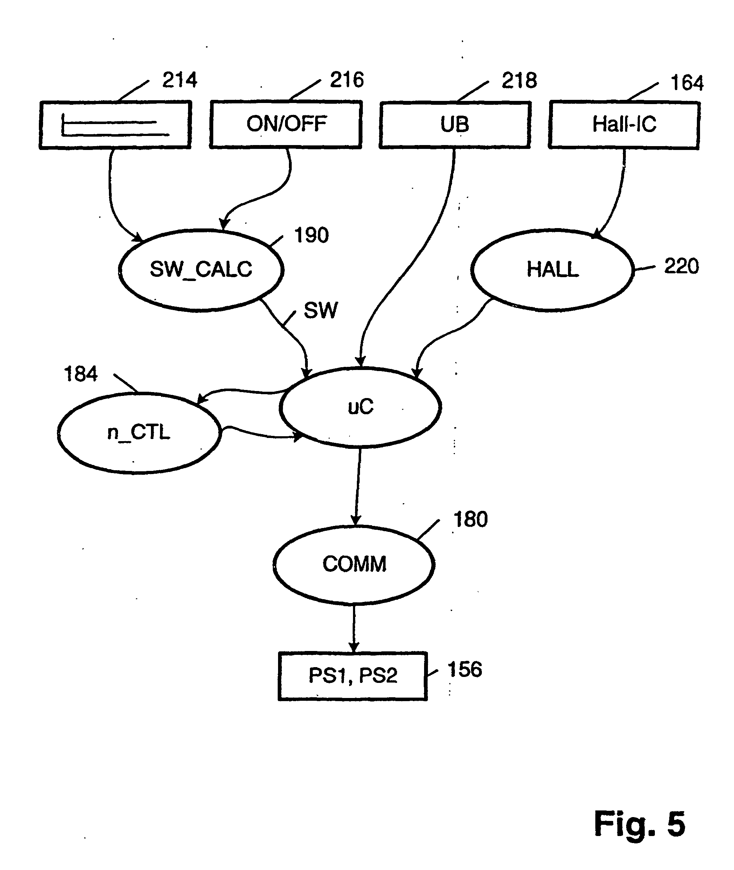

Fig. 5 zeigt, wie bei einem solchen Motor die einzelnen Funktionen ineinander greifen.

Bei 214 wird ein Signal am NTC-Widerstand 52 erzeugt und in dem Modul 190 verarbeitet, so dass man den Wert SW erhält.

Bei 216 werden Signale ON/OFF für das Ein- oder Ausschalten des Motors 156 zugeführt, und diese laufen ebenfalls über das Modul 190.

Bei 218 wird die Betriebsspannung $U_B$ zugeführt und diese kann z. B. in der Weise berücksichtigt werden, dass bei zu niedriger Betriebsspannung der Motor abgeschaltet wird oder dass bei zu hoher Betriebsspannung bestimmte Veränderungen im Programm vorgenommen werden.

Bei 164 ist der Hall-IC 164 dargestellt, der das Signal HALL erzeugt und dieses wird in einem Verarbeitungsmodul 220 verarbeitet und liefert Informationen über die augenblickliche Stellung und Drehzahl des Rotors 162.

Schließlich ist das Kommutierungsmodul COMM 180 vorgesehen, welches die beiden Endstufen PS 1, PS 2 im Motor 156 steuert.

Fig. 5 zeigt, dass zwischen den einzelnen Modulen Interaktionen bestehen, die ggf. bei der Ausgestaltung des Programmes berücksichtigt werden müssen, sofern dieses in einem ECM 156 verwendet wird.

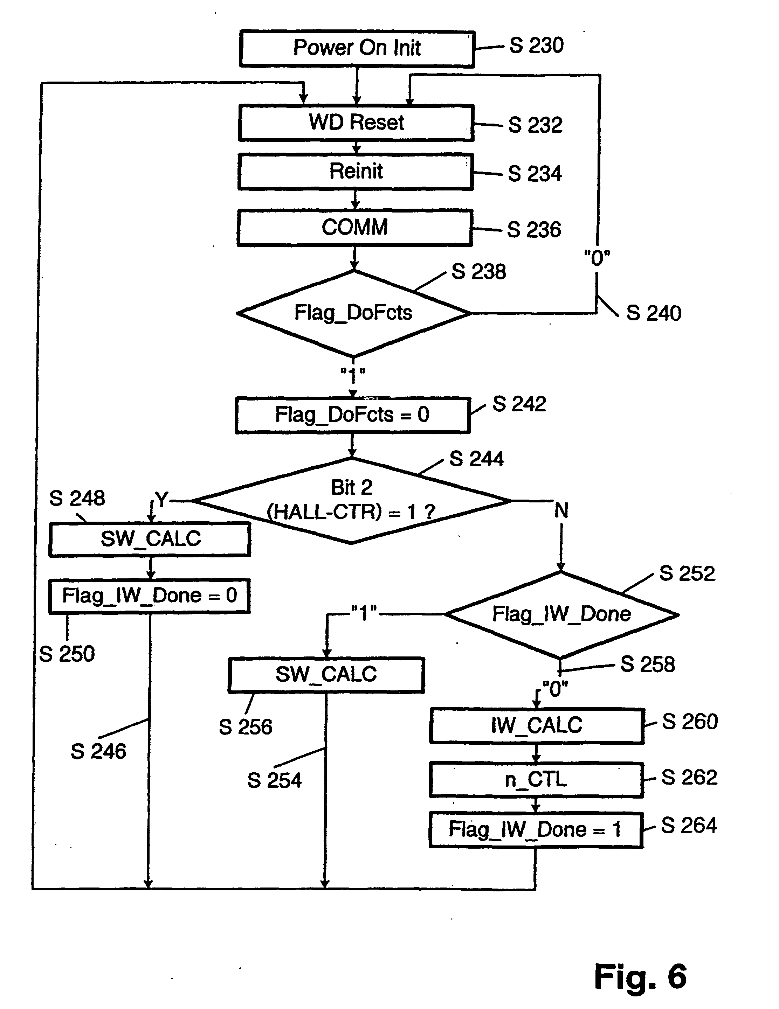

**Fig. 6** zeigt die typische Grundstruktur eines Programmes, wie es bevorzugt zur Steuerung der diversen Funktionen des Motors 156 verwendet wird.

Im Schritt S230 erfolgt eine Initialisierung beim Einschalten, bei der verschiedene Parameter auf Eingangswerte gesetzt werden. Im Schritt S232 wird der Watchdog WD des Rechners 20 zurückgesetzt, und im Schritt S234 erfolgt bei jedem Durchlauf eine Reinitialisierung bestimmter Werte, um einen Absturz des µC 20 zu vermeiden. Bei S236 wird die Kommutierung gesteuert. Im Schritt S238 wird ein Flag_DoFcts abgefragt, und wenn es den Wert 0 hat, geht das Programm über eine kurze Schleife 240 zurück zu S232. Wenn dieses Flag den Wert 1 hat, wird es im Schritt S242 auf 0 zurückgesetzt. Dieses Flag (S238) wird bei jedem Hall-Interrupt (Fig. 8) auf 1 gesetzt, also in Fig. 4 an den Stellen 1, 2, 3, 4 etc. des Signals HALL.

Im anschließenden Schritt S244 wird das Bit 2 von HALL _CTR 168 abgefragt.

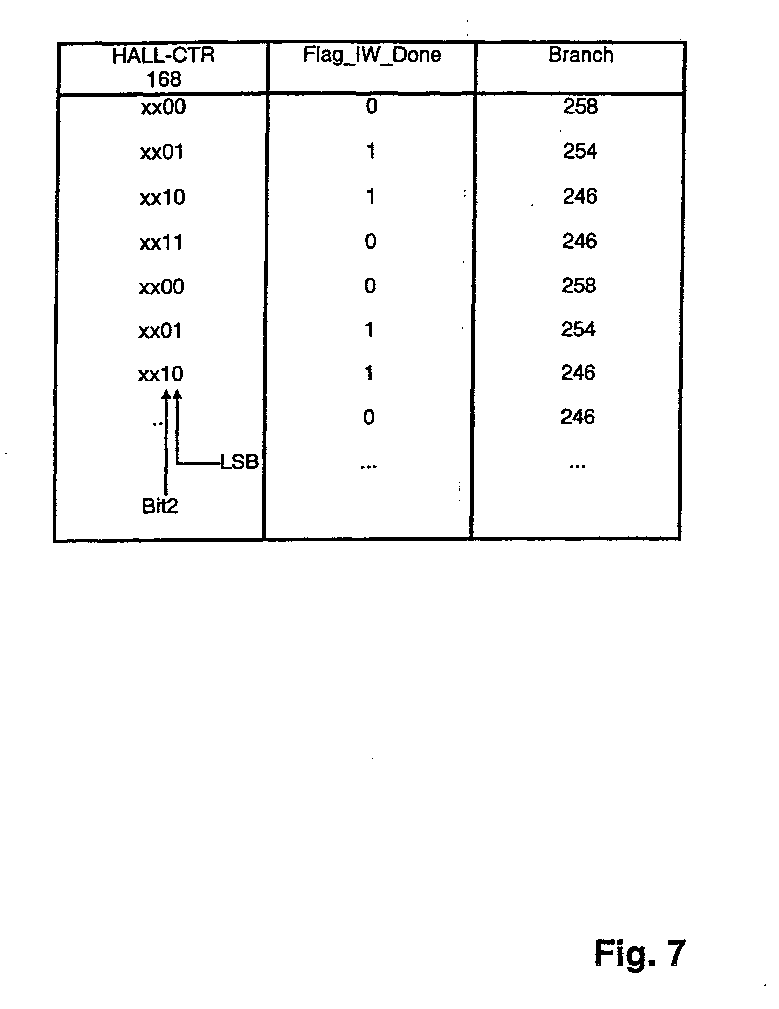

Wie in **Fig. 7** dargestellt, nimmt dieser binäre Ringzähler in seinen zwei niedrigsten Stellen die Zahlenfolge 00-01-10-11-00 etc. an. Hat Bit 2 den Wert 1, so verzweigt das Programm nach links in einen Zweig 246. Hat es den Wert 0, so verzweigt es nach rechts. Im linken Zweig 246 folgt bei S248 eine der Phasen der Sollwerterfassung, wie in den Fig. 1 bis 3 beschrieben, und bei S250 wird das Flag_IW_Done auf 0 gesetzt. Anschließend geht das Programm zurück zum Schritt S232.

Lautet bei S244 die Antwort Nein, so geht das Programm zum Schritt S252 und prüft dort den Wert von Flag_IW_Done. Falls dieser Wert 1 beträgt, geht das Programm zur Schleife 254, führt dort in einem Schritt S256 eine der bei den Fig. 1 bis 3 beschriebenen Phasen der Sollwerterfassung SW_CALC aus und geht dann zurück zu S232.

Beträgt in S252 der Wert von Flag_IW_Done 0, so geht das Programm zur rechten Schleife 258. Dort erfolgt im Schritt S260 die Istwerterfassung IW_CALC, d. h. die augenblickliche Drehzahl des Motors 156 wird als digitaler Wert erfasst.

Anschließend erfolgt im Schritt S262 die Drehzahlregelung n_CTL aufgrund des erfassten Istwertes und des erfassten Sollwertes, und dann wird in S264 das Flag IW_Done auf 1 gesetzt, und das Programm geht zurück zu S232.

Bei laufendem Motor 156 wird nach jeder Änderung des Signals HALL einmal eine der drei langen Schleifen 246, 254 oder 258 abgearbeitet. Anschließend wird bis zur nächsten Änderung von HALL nur die kurze Schleife 240 mit kurzen zeitlichen Abständen wiederholt, z.B. alle 100 µs.

Da die Erfassung und Berechnung des Sollwertes, wie sie bei den Fig. 1 bis 3 beschrieben wurde, viel Zeit benötigt, wurde sie in vorteilhafter Weise auf die Schleifen 246, 254 verteilt. Fig. 4 zeigt, dass bei diesem Beispiel pro voller Drehung des Rotors 162 vier Änderungen des Signals HALL auftreten. Wie Fig. 7 zeigt, wird der Zweig 246 pro voller Drehung des vierpoligen Rotors 162 zwei Mal durchlaufen, der Zweig 254 einmal und der Zweig 258 ebenfalls nur einmal. Pro Umdrehung wird also bei drei Änderungen des Signals HALL, z.B. den Änderungen 2, 3 und 4 der Fig. 4, je eine der Phasen der Sollwertberechnung SW_CALC ausgeführt, und nur bei einer Änderung des Signals HALL, z.B. der Änderung 1 der Fig. 4, wird eine Erfassung des Istwertes IW_CALC ausgeführt. Dabei ist vorteilhaft, dass die Erfassung des Istwertes mit den Werten einer vollen Rotorumdrehung erfolgen kann, was wesentlich genauer ist als die Erfassung über nur eine Viertel-Umdrehung.

Die drei Zweige 246, 254 und 258 werden bevorzugt so ausgelegt, dass ihre Ausführung etwa gleich lange dauert.

Es ist darauf hinzuweisen, dass in den Schritten S248, S256 der Fig. 6 jeweils diejenige Phase der Sollwerterfassung ausgeführt wird, die im Augenblick vom beschriebenen Phasenzähler angegeben wird. Es kann also z. B. sein, dass im Schritt S256 beim einen Durchlauf die Phase = 0 ausgeführt wird, beim nächsten Durchlauf die Phase = 3, beim nächsten Durchlauf die Phase = Sensor Break etc. Die komplette Erfassung des Sollwertes wird folglich auf etwa zwei Rotorumdrehungen verteilt, was genügend genau ist, da sich der Sollwert in dieser kurzen Zeit nur wenig ändert. Die Berechnung des Sollwertes dauert ziemlich lange, aber durch diese Verteilung auf zwei Umdrehungen kann sie in mehrere kleine Stücke zerlegt werden und stört dann die Kommutierung des Motors 156 nicht.

Fig. 8 zeigt eine Routine S200, die zur Bedienung von Interrupts dient, welche den Programmablauf unterbrechen.

Fig. 4 zeigt das Signal HALL, von dem vier Flanken 1, 2, 3, 4 dargestellt sind. Bei jeder dieser Flanken wird die Interruptroutine S200 der Fig. 8 aufgerufen, damit durch den TIMER 192 (Fig. 4) der Zeitpunkt genau gemessen werden kann, an dem die betreffende Flanke aufgetreten ist.

Wenn z.B. die Flanke 1 bei t1 = 64.327 µs aufgetreten ist, und die Flanke 2 bei t2 = 65.400 µs, so benötigte der Rotor 162 für die Drehung zwischen Flanke 1 und 2, also für eine Viertel-Umdrehung, eine Zeit von

$$t2 - t1 = 65.400 - 64.327 = 1073 \ \mu s \qquad (2)$$

Für eine volle Umdrehung benötigt der Rotor 162 also
4 * 1073 = 4292 μs = 0,004292 Sekunden.
Daraus ergibt sich eine Drehzahl von

$$1/0,004292 = 232,99 \text{ U/s} = 60 * 232,99 = 13.979,5 \text{ U/min} \tag{3}$$

Auf diese Weise kann also der Istwert IW der Drehzahl sehr genau berechnet werden. Voraussetzung ist jedoch, dass die Zeitpunkte t1, t2, ... sehr genau gemessen werden. Diese Zeitpunkte werden auch für die exakte Steuerung der Kommutierung benötigt.

Wenn ein Interrupt auftritt, wird zuerst in S202 geprüft, ob ein Hall-Interrupt vorliegt, also eine der Flanken des Signals HALL. Ein solcher Hall-Interrupt hat die höchste Priorität und unterbricht alle anderen Programmabläufe. Falls JA, geht das Programm zu S204 und berechnet dort den tatsächlichen Wert IW der Drehzahl, gewöhnlich gemäß der obigen Gleichung (2), also in Form der Zeit, die der Rotor 162 im Augenblick benötigt, um sich um einen vorgegebenen Drehwinkel zu drehen.

Anschließend werden in S206 "CALC COMM" Berechnungen zur Steuerung der Kommutierung ausgeführt, und das Flag_DoFcts, das in den Schritten S238, S242 der Fig. 6 die Berechnungsvorgänge steuert, wird auf 1 gesetzt, damit im Anschluss an jeden Hall-Interrupt einmal eine der unteren Schleifen 246, 254 oder 258 der Fig. 6 durchlaufen wird. Ggf. kann in S238 (Fig. 6) auch eine zweite oder sogar dritte Bedingung abgefragt werden, damit die unteren Schleifen 246, 254 oder 258 an einer gewünschten Stelle der Rotordrehung ausgeführt werden, wie das in der deutschen Patentanmeldung 101 61 688.0 der Anmelderin vom 15. Dezember 2001 (D254) beschrieben ist, entsprechend der PCT-Anmeldung ....

Anschließend wird in S208 der Hallzähler HALL_CTR 168 (Fig. 4) um 1 hinaufgezählt, wie bei Fig. 7 beschrieben. Danach geht die Routine zu S210 Return.

Lautet in S202 die Antwort NEIN, so geht das Programm zu S212, prüft, welcher andere Interrupt vorliegt, führt diesen aus, und geht dann ebenfalls zu S210 Return.

Die Interruptroutine S200 der Fig. 8 dient also vor allem dazu, die Zeitpunkte der Flanken 1, 2, 3, 4, ... des Signals HALL (Fig. 4) sehr exakt zu messen, da eine derartige exakte Messung Voraussetzung für einen ruhigen Lauf des Motors 156 mit der gewünschten Drehzahl ist. Durch das Setzen des Flag_DoFcts in S206 und das Hinaufzählen des Hallzählers in S208 wird gleichzeitig bestimmt, welche der Schleifen 246, 254 oder 258 der Fig. 6 als nächstes ausgeführt wird, und auf diese Weise können die zu erledigenden Rechenaufgaben optimal in die verfügbare Rechenzeit eingepasst und an der richtigen Drehstellung des Rotors 162 ausgeführt werden.

Das Flussdiagramm der Fig. 6 kann man sich wie folgt verständlich machen:

Die Abfrage in S238 ist wie eine erste Ampel. Diese wird, gesteuert von der Drehstellung des Rotors 162, vier mal pro Rotorumdrehung auf Grün gestellt, beim Ausführungsbeispiel z.B. dort, wo eine Flanke des Signals HALL vorliegt, und in diesem Fall werden die Schritte S242 und S244 erreicht. Die übrige Zeit steht diese Ampel S238 auf Rot, so dass mit sehr kurzen Abständen die Schleife 240 durchlaufen wird.

Die nächste Ampel ist S244. Diese wird gesteuert vom zweiten Bit des Hallzählers 168, wie in Fig. 7 dargestellt. Das wirkt so, wie wenn diese "Ampel" über ein Untersetzungsgetriebe von der Rotordrehung gesteuert würde.

Steht diese Ampel auf Grün (JA), so wird die Schleife 246 durchlaufen, vgl. Fig. 7. Steht sie auf Rot (NEIN), so geht die Routine zu S252. Dort verzweigt das Programm entweder zur Schleife 254 oder zur Schleife 258.

Nach jeder der Schleifen 246, 254 oder 258 geht das Programm zurück zu S232.

Auf diese Weise kann man an vorgegebenen Drehstellungen des Rotors 162 bestimmte Programmschritte ausführen, die dort notwendig sind, z.B. die Schritte S232, 234, 236 für die Kommutierung, welche in den Zeitbereichen ausgeführt werden müssen, in denen eine Kommutierung zu erwarten ist. Bei den Schritten, die notwendig sind, um die Drehzahl zu regeln (S262) oder Vorgabewerte für die Drehzahlregelung zu berechnen (S248, S256, S260), genügt es, sie einmal pro Rotorumdrehung oder einmal pro zwei Rotorumdrehungen auszuführen, weil sich die Drehzahl innerhalb dieser Zeitspanne nur wenig ändert.

Die Messung könnte auch in der Weise erfolgen, dass beide Zeiten $T_1$ und $T_2$ nicht beim Laden des Kondensators 80 gemessen werden, sondern beim Entladen. Auch in diesem Fall spielt die Größe des Kondensators 80 für die Genauigkeit der Messung keine Rolle.

**Patentansprüche**

**1.** Verfahren zur Digitalisierung einer Spannung, welches folgende Schritten aufweist:

Ein Kondensator (80) wird über eine Impedanz auf einen von der zu digitalisierenden Spannung abhängigen Spannungswert (Um) aufgeladen; es wird ermittelt, in welchem von einer Mehrzahl von Spannungsbereichen, dieser Spannungswert (Um) liegt, und die beiden Grenzen des ermittelten Spannungsbereichs werden als erste Grenze und als zweite Grenze bestimmt;

die Spannung am Kondensator (80) wird mittels eines Ladungsänderungskreises, welcher eine Impedanz enthält, bis zur ersten Grenze verändert, und eine hierfür benötigte erste Zeit ($T_1$) wird erfasst;

die Spannung am Kondensator (80) wird bis zur zweiten Grenze verändert; die Spannung am Kondensator (80) wird mittels des Ladungsänderungskreises von der zweiten Grenze bis zur ersten Grenze verändert, und eine dafür benötigte zweite Zeit ($T_2$) wird erfasst;

ausgehend von erster Zeit ($T_1$) und zweiter Zeit ($T_2$) wird ein digitaler Wert berechnet, welcher als Maß dafür dient, um wieviel der Spannungswert (Um) am Kondensator (80) von einer der beiden Grenzen des ermittelten Spannungsbereichs differiert.

2. Verfahren nach Anspruch 1, bei welchem ein Impedanzwandler (66) verwendet wird, dessen Eingang (72) mit der Spannungsquelle und dessen Ausgang über die Impedanz mit dem Kondensator (80) verbunden ist.

3. Verfahren nach Anspruch 1 oder 2, bei welchem eine Widerstandskette (22) in Form einer Reihenschaltung von über Verbindungspunkte (32, 34, 36, 38) verbundenen Widerständen (24, 26, 28, 30) verwendet wird, welche Reihenschaltung an einer im wesentlichen konstanten Spannung liegt,

und die Potenziale an diesen Verbindungspunkten (32, 34, 36, 38) nacheinander mit dem Spannungswert (Um) am Kondensator (80) verglichen werden, um die erste Grenze und die zweite Grenze zu bestimmen.

4. Verfahren nach Anspruch 3, bei welchem dann, wenn der Spannungswert (Um) am Kondensator (80) größer ist als das Potenzial an allen Verbindungspunkten der Widerstandskette, zum Kondensator (80) ein Widerstand (94) parallel geschaltet wird, um den Spannungswert am Kondensator (80) zu reduzieren,

und anschließend erneut die Potenziale an den Verbindungspunkten der Widerstände mit dem Spannungswert (Um) am Kondensator (80) verglichen werden, um die erste und die zweite Grenze zu bestimmen.

5. Verfahren nach einem der vorhergehenden Ansprüche, bei welchem zwischen der Erfassung der ersten Zeit ($T_1$) und der Erfassung der zweiten Zeit ($T_2$) eine Routine ausgeführt wird, deren Programmschritte (Fig. 6: S232, 234, 236) der Steuerung eines Elektromotors (156) dienen.

6. Verfahren nach einem der vorhergehenden Ansprüche, bei welchem zwischen der Erfassung der zweiten Zeit ($T_2$) und der Auswertung der zweiten Zeit eine Routine ausgeführt wird, deren Programmschritte (Fig. 6: S232, 234, 236) der Steuerung eines Elektromotors (156) dienen.

7. Anordnung zur Digitalisierung einer Spannung, welche aufweist:

Einen Kondensator (80);

einen eine Impedanz (76) aufweisenden Ladekreis (66, 76) zur Aufladung dieses Kondensators (80) auf einen von der zu digitalisierenden Spannung abhängigen Spannungswert (Um);

einen Mikroprozessor (20) zur Grob-Klassifizierung dieses Spannungswertes (Um) in einen von einer Mehrzahl von Spannungsbereichen, welcher Spannungsbereich eine erste Grenze und eine zweite Grenze aufweist;

eine Ladungsänderungsvorrichtung (84, 88) zur Veränderung der Spannung am Kondensator (80) bis zur ersten Grenze des ermittelten Spannungsbereichs und zur Erfassung einer hierfür benötigten ersten Zeit ($T_1$);

eine Ladungsänderungsvorrichtung (84, 90) zur Veränderung der Spannung am Kondensator (80) bis zur zweiten Grenze des ermittelten Spannungsbereichs;

eine Ladungsänderungsvorrichtung (84, 88) zur Veränderung der Spannung am Kondensator (80) von der zweiten Grenze bis zur ersten Grenze und zur Erfassung einer hierfür benötigten zweiten Zeit ($T_2$);

und eine Rechenvorrichtung (44) zur Berechnung eines digitalen Wertes (LSB) als Funktion von erster Zeit ($T_1$) und zweiter Zeit ($T_2$).

8. Anordnung nach Anspruch 7, bei welcher der Mikroprozessor (20) zur Steuerung (Fig. 1: A, B) mindestens einer Ladungsänderungsvorrichtung (88, 90) dient.

9. Anordnung nach Anspruch 7 oder 8, bei welcher eine vom Mikroprozessor (20) gesteuerte Messbereichs-Umschaltvorrichtung (94, 96) vorgesehen ist, welche aktiviert wird, wenn der Spannungswert (Um) am Kondensator (80) außerhalb der vorhandenen Spannungsbereiche liegt.

**10.** Anordnung nach einem der Ansprüche 7 bis 9, bei welcher eine Rechenvorrichtung (Fig. 3: S144) vorgesehen ist, welche aus einem durch die Grob-Klassifizierung erhaltenen digitalen Wert (MSB) und dem als Funktion von erster und zweiter Zeit berechneten digitalen Wert (LSB) einen kombinierten digitalen Wert bildet, welcher gegenüber dem durch die Grob-Klassifizierung erhaltenen digitalen Wert eine höhere Genauigkeit aufweist.

**11.** Anordnung nach einem der Ansprüche 7 bis 10, bei welcher im Ladekreis (66, 76) des Kondensators (80) ein Impedanzwandler (66) vorgesehen ist, welcher eingangsseitig von einer Spannungsquelle (52, 60, 64) steuerbar ist, deren analoge Spannung in ein digitales Signal umgeformt werden soll.

**12.** Anordnung nach einem der Ansprüche 7 bis 11, bei welcher der Mikroprozessor (20) auch zur Kommutierung eines elektronisch kommutierten Motors (156) dient.

**13.** Anordnung nach Anspruch 12, bei welcher das Programm (Fig. 3) des Mikroprozessors (20) verschiedene Aufrufe für die Digitalisierung aufweist, wobei in jedem Aufruf nur ein Teil der Digitalisierung ausgeführt wird.

**14.** Verwendung einer Anordnung nach einem der Ansprüche 7 bis 13 zur temperaturabhängigen Steuerung der Drehzahl eines Lüfters (156, 83).

**15.** Verwendung nach Anspruch 14 zur Digitalisieung einer Temperatur für die temperaturabhängige Steuerung der Drehzahl eines Lüfters (156, 83).

**16.** Verwendung nach Anspruch 14 oder 15, bei welchem die Anordnung zur Drehzahlsteuerung von der augenblicklichen Lage des Rotors (162) eines den Lüfter (83) antreibenden Motors (156) gesteuert ist.

**17.** Verwendung eines Verfahrens nach einem der Ansprüche 1 bis 7 zur temperaturabhängigen Steuerung der Drehzahl eines Lüfters (156, 83) und insbesondere zur Digitalisierung einer Temperatur für die temperaturabhängige Steuerung der Drehzahl eines Lüfters (156, 83).

**18.** Verwendung nach Anspruch 17, bei welcher die Ausführung des Verfahrens durch die augenblicklichen Lage des Rotors (162) eines den Lüfter (83) antreibenden Motors (156) gesteuert wird (Fig. 7).

**Claims**

**1.** Method for digitising a voltage, which comprises the following steps:

a capacitor (80) is charged through an impedance to a voltage value (Um) dependent on the voltage to be digitised;
the voltage range in a plurality of voltage ranges in which this voltage value (Um) lies is identified, and the two limits of the identified voltage range are defined as the first limit and the second limit;
the voltage at the capacitor (80) is changed to the first limit by means of a charge changing circuit which comprises an impedance, and a first time (T1) required for this is measured;
the voltage at the capacitor (80) is changed to the second limit;
the voltage at the capacitor (80) is changed from the second limit to the first limit by the charge changing circuit, and a second time (T2) required for this is measured;
departing from the first time (T1) and second time (T2) a digital value is calculated which serves as a measurement for the amount by which the voltage value (Um) at the capacitor (80) differs from one of the two limits of the identified voltage range.

**2.** Method according to claim 1, in which an impedance converter (66) is used, the input (72) of which is connected to the voltage source and the output of which is connected through the impedance to the capacitor (80).

**3.** Method according to claim 1 or 2, in which a resistor chain (22) in the form of a series circuit of resistors (24, 26, 28, 30) connected through connection points (32, 34, 36, 38) is used, which series circuit lies at an essentially constant voltage, and the potentials at these connection points (32, 34, 36, 38) are compared one after another with the voltage value (Um) at the capacitor (80) in order to define the first limit and the second limit.

**4.** Method according to claim 3, in which, when the voltage value (Um) at the capacitor (80) is greater than the potential at all the connection points of the resistor chain, a resistor (94) is connected parallel to the capacitor (80) in order to reduce the voltage value at the capacitor (80), and then the potentials at the connection points of the resistors are again compared with the voltage value (Um) at the capacitor (80) in order to define the first and the second limit.

5. Method according to one of the preceding claims, in which a routine, the programme steps of which (fig. 6: S232, 234, 236) serve for control of an electrical motor (156), is executed between the measurement of the first time (T1) and the measurement of the second time (T2).

6. Method according to one of the preceding claims, in which a routine, the programme steps of which (fig. 6: S232, 234, 236) serve for control of an electric motor (156), is executed between the measurement of the second time (T2) and the evaluation of the second time.

7. Arrangement for digitising a voltage, which comprises:

   a capacitor (80);
   a charging circuit (66, 76) comprising an impedance (76) for charging this capacitor (80) to a voltage value (Um) dependent on the voltage to be digitised;
   a microprocessor (20) for rough classification of this voltage value (Um) in one of a plurality of voltage ranges, which voltage range comprises a first limit and a second limit;
   a charge changing device (84, 88) for changing the voltage at the capacitor (80) to the first limit of the identified voltage range and for measuring a first time (T1) required for this;
   a charge changing device (84, 90) for changing the voltage at the capacitor (80) to the second limit of the identified voltage range;
   a charge changing device (84, 88) for changing the voltage at the capacitor (80) from the second limit to the first limit and for measuring a second time (T2) required for this;
   and a calculating device (44) for calculating a digital value (LSB) as a function of the first time (T1) and the second time (T2).

8. Arrangement according to claim 7, in which the microprocessor (20) serves for control (fig. 1: A, B) of at least one charge changing device (88, 90).

9. Arrangement according to claim 7 or 8, in which a measurement range switching device (94, 96) controlled by the microprocessor (20) is provided, which is device activated when the voltage value (Um) at the capacitor (80) lies outside the existing voltage ranges.

10. Arrangement according to one of claims 7 to 9, in which a calculating device (fig. 3: S144) is provided, which from a digital value (MSB) obtained by the rough classification and the digital value (LSB) calculated as a function of the first and second times forms a combined digital value which has a higher accuracy than the digital value obtained through the rough classification.

11. Arrangement according to one of claims 7 to 10, in which an impedance converter (66) is provided in the charging circuit (66, 76) of the capacitor (80), which impedance converter is controllable on the input side by a voltage source (52, 60, 64) the analogue voltage of which is to be converted into a digital signal.

12. Arrangement according to one of claims 7 to 11, in which the microprocessor (20) also serves for commutation of an electronically commutated motor (156).

13. Arrangement according to claim 12, in which the programme (fig. 3) of the microprocessor (20) comprises different calls for the digitisation, and only one part of the digitisation is carried out in each call.

14. Use of an arrangement according to one of claims 7 to 13 for temperature-dependent control of the rotational speed of a fan (156, 83).

15. Use as in claim 14 for digitising a temperature for temperature-dependent control of the rotational speed of a fan (156, 83).

16. Use as in claim 14 or 15, in which the arrangement for control of the rotational speed is controlled by the instantaneous position of the rotor (162) of a motor (156) driving the fan (83).

**17.** Use of a method as in one of claims 1 to 7 for temperature-dependent control of the rotational speed of a fan (156, 83) and in particular for digitising a temperature for temperature-dependent control of the rotational speed of a fan (156, 83).

**18.** Use as in claim 17, in which the implementation of the method is controlled by the instantaneous position of the rotor (162) of a motor (156) driving the fan (83) (fig. 7).

**Revendications**

**1.** Procédé pour numériser une tension, lequel présente les étapes suivantes :

on charge via une impédance un condensateur (80) à une valeur de tension ($U_m$) dépendante de la tension à numériser ;
on détermine dans laquelle d'une pluralité de plages de tension cette valeur de tension ($U_m$) se situe et on définit les deux limites de la plage de tension déterminée en tant que première limite et en tant que deuxième limite ;
on fait varier la tension au condensateur (80) jusqu'à la première limite au moyen d'un circuit de variation de charge qui contient une impédance et on saisit un premier temps ($T_1$) nécessaire pour cela ;
on fait varier la tension au condensateur (80) jusqu'à la deuxième limite ;
on fait varier la tension au condensateur (80) de la deuxième limite à la première limite au moyen du circuit de variation de charge et on saisit un deuxième temps ($T_2$) nécessaire pour cela ;
à partir du premier temps ($T_1$) et du deuxième temps ($T_2$), on calcule une valeur numérique qui sert de mesure indiquant de combien la valeur de tension ($U_m$) au condensateur (80) diffère de l'une des deux limites de la plage de tension déterminée.

**2.** Procédé selon la revendication 1, dans lequel on utilise un convertisseur d'impédance (66) dont l'entrée (72) est reliée à la source de tension et dont la sortie est reliée au condensateur (80) via l'impédance.

**3.** Procédé selon la revendication 1 ou 2, dans lequel on utilise une chaîne de résistances (22) sous la forme d'un montage en série de résistances (24, 26, 28, 30) reliées par des points de liaison (32, 34, 36, 38), lequel montage en série est soumis à une tension essentiellement constante, et on compare successivement les potentiels à ces points de liaison (32, 34, 36, 38) à la valeur de tension ($U_m$) au condensateur (80) afin de définir la première limite et la deuxième limite.

**4.** Procédé selon la revendication 3, dans lequel, lorsque la valeur de tension ($U_m$) au condensateur (80) est supérieure au potentiel à tous les points de liaison de la chaîne de résistances, on couple une résistance (94) en parallèle avec le condensateur (80) pour réduire la valeur de tension au condensateur (80),
et on compare ensuite de nouveau les potentiels aux points de liaison des résistances à la valeur de tension ($U_m$) au condensateur (80) afin de définir la première limite et la deuxième limite.

**5.** Procédé selon l'une des revendications précédentes, dans lequel on exécute entre la saisie du premier temps ($T_1$) et la saisie du deuxième temps ($T_2$) une routine dont les pas de programme (fig. 6 : S232, 234, 236) servent à la commande d'un moteur électrique (156).

**6.** Procédé selon l'une des revendications précédentes, dans lequel on exécute entre la saisie du deuxième temps ($T_2$) et l'évaluation du deuxième temps une routine dont les pas de programme (fig. 6 : S232, 234, 236) servent à la commande d'un moteur électrique (156).

**7.** Dispositif pour numériser une tension, lequel présente :

un condensateur (80) ;
un circuit de charge (66, 76) présentant une impédance (76) pour charger ce condensateur (80) à une valeur de tension ($U_m$) dépendante de la tension à numériser ;
un microprocesseur (20) pour la classification grossière de cette valeur de tension ($U_m$) dans une parmi une pluralité de plages de tension, laquelle plage de tension présente une première limite et une deuxième limite ;
un dispositif de variation de charge (84, 88) pour faire varier la tension au condensateur (80) jusqu'à la première limite de la plage de tension déterminée et pour saisir un premier temps ($T_1$) nécessaire pour cela ;

un dispositif de variation de charge (84, 90) pour faire varier la tension au condensateur (80) jusqu'à la deuxième limite de la plage de tension déterminée ;

un dispositif de variation de charge (84, 88) pour faire varier la tension au condensateur (80) de la deuxième limite à la première limite de la plage de tension déterminée et pour saisir un deuxième temps ($T_2$) nécessaire pour cela ;

et un dispositif de calcul (44) pour calculer une valeur numérique (LSB) en tant que fonction du premier temps ($T_1$) et du deuxième temps ($T_2$).

**8.** Dispositif selon la revendication 7, dans lequel le microprocesseur (20) sert à la commande (fig. 1 : A, B) d'au moins un dispositif de variation de charge (88, 90).

**9.** Dispositif selon la revendication 7 ou 8, dans lequel il est prévu un dispositif de commutation de plages de mesure (94, 96) commandé par le microprocesseur (20), lequel est activé quand la valeur de tension ($U_m$) au condensateur (80) se situe en dehors des plages de tension disponibles.

**10.** Dispositif selon l'une des revendications 7 à 9, dans lequel il est prévu un dispositif de calcul (fig. 3 : S144), lequel forme à partir d'une valeur numérique (MSB) obtenue par la classification grossière et de la valeur numérique (LSB) calculée en tant que fonction du premier et du deuxième temps une valeur numérique combinée qui présente une précision plus élevée que la valeur numérique obtenue par la classification grossière.

**11.** Dispositif selon l'une des revendications 7 à 10, dans lequel il est prévu dans le circuit de charge (66, 76) du condensateur (80) un convertisseur d'impédance (66), lequel peut être commandé côté entrée par une source de tension (52, 60, 64) dont la tension analogique doit être convertie en un signal numérique.

**12.** Dispositif selon l'une des revendications 7 à 11, dans lequel le microprocesseur (20) sert aussi à la commutation d'un moteur à commutation électronique (156).

**13.** Dispositif selon la revendication 12, dans lequel le programme (fig. 3) du microprocesseur (20) présente différents appels pour la numérisation, une partie seulement de la numérisation étant effectuée à chaque appel.

**14.** Utilisation d'un dispositif selon l'une des revendications 7 à 13 pour commander en fonction de la température la vitesse de rotation d'un ventilateur (156, 83).

**15.** Utilisation selon la revendication 14 pour numériser une température pour la commande en fonction de la température de la vitesse de rotation d'un ventilateur (156, 83).

**16.** Utilisation selon la revendication 14 ou 15, dans laquelle le dispositif de commande de vitesse de rotation est commandé par la position actuelle du rotor (162) d'un moteur (156) entraînant le ventilateur (83).

**17.** Utilisation du procédé selon l'une des revendications 1 à 7 pour commander en fonction de la température la vitesse de rotation d'un ventilateur (156, 83) et en particulier pour numériser une température pour la commande en fonction de la température de la vitesse de rotation d'un ventilateur (156, 83).

**18.** Utilisation selon la revendication 17, dans laquelle la réalisation du procédé est commandée par la position actuelle du rotor (162) d'un moteur (156) entraînant le ventilateur (83) (fig. 7).

Fig. 1

EP 1 324 496 B1

Fig. 2

```
            ┌─────────────────────┐
            │     SW-Routine       │
            └─────────────────────┘
              118                                    ┌──────────────────┐  S 122
                 │           S 120                   │                  │
              ╱─────────╲                            │   Charge C 80    │────────┐
             ╱  Phase = 0 ? ╲───Y─────────────────►  │                  │        │
              ╲─────────╱                            └──────────────────┘        │
                 │N                                                              │
                 ▼                                   ┌──────────────────┐  S 128  │
              ╱─────────╲       S 126                │                  │        │
             ╱  Phase = 1 ? ╲───Y─────────────────►  │     Find "N"     │──────► │
              ╲─────────╱                            │                  │        │
                 │N                                  └──────────────────┘        │
                 ▼                                   ┌──────────────────┐  S 132  │
              ╱─────────╲       S 130                │                  │        │
             ╱  Phase = 3 ? ╲───Y─────────────────►  │   Discharge      │        │
              ╲─────────╱                            │    to "N"        │        │
                 │N                                  └──────────────────┘        │
                 ▼                                           │                   │
              ╱─────────╲       S 138                        │                   │
             ╱  Phase = 2 ? ╲───Y───────────────────────────►│                   │
              ╲─────────╱                                    │                   │
                 │N                                          ▼                   │
                 ▼                                   ┌──────────────────┐  S 136  │
              ╱─────────╲       S 140                │                  │        │
             ╱  Phase = 4 ? ╲───Y─────────────────►  │  Charge to "N+1" │──────► │
              ╲─────────╱                            │                  │        │
                 │N                                  └──────────────────┘        │
                 ▼                                   ┌──────────────────┐  S 144  │
              ╱─────────╲       S 142                │                  │        │
             ╱  Phase = 5 ? ╲───Y─────────────────►  │   Measure Tx     │──────► │
              ╲─────────╱                            │   LSB + MSB      │        │
                 │N                                  └──────────────────┘        │
                 ▼                                   ┌──────────────────┐  S 148  │
              ╱─────────╲       S 146                │                  │        │
             ╱  Phase =   ╲───Y─────────────────►    │    Control       │──────► │
             ╲ Sensor Break ? ╱                      │  Sensor Fault    │        │
              ╲─────────╱                            └──────────────────┘        │
                 │N       S 150                                                  │
                 ▼                                   ┌─────────────────────┐     │
            ┌──────────┐                             │ Phase := Phase + 1  │◄────┘
            │   CALC   │                             └─────────────────────┘
            └──────────┘                                        │    S 149
            ┌──────────┐                                        │
            │ Phase = 0│──────────────────────────┐            │
            └──────────┘                          │            │
                 S 152                             ▼            ▼
                                           ┌──────────────────┐
                                           │      Return      │── S 124
                                           └──────────────────┘
```

**Fig. 3**

**Fig. 4**

**Fig. 5**

**Fig. 6**

| HALL-CTR 168 | Flag_IW_Done | Branch |
|:---:|:---:|:---:|
| xx00 | 0 | 258 |
| xx01 | 1 | 254 |
| xx10 | 1 | 246 |
| xx11 | 0 | 246 |
| xx00 | 0 | 258 |
| xx01 | 1 | 254 |
| xx10 | 1 | 246 |
| | 0 | 246 |
| .. | ... | ... |
| LSB | | |
| Bit2 | | |

**Fig. 7**

INTERRUPT-ROUTINE — S 200

Hall-Interrupt ? — S 202

Y

CALC IW — S 204

CALC COMM

Flag_DoFcts =1 — S 206

Increment
Hall_CTR 168 — S 208

N

OTHER INTERRUPTS — S 212

Return — S 210

## Fig. 8